# EUROPEAN PATENT SPECIFICATION

(11) **EP 4 307 354 B1**
(45) Date of publication and mention of the grant of the patent: **19.08.2026**
(21) Application number: 22217112.6
(22) Date of filing: 29.12.2022
(51) Int. Cl.: H10P 72/00

(54) **LOW-TEMPERATURE/BEOL-COMPATIBLE HIGHLY SCALABLE GRAPHENE SYNTHESIS TOOL**
NIEDRIGTEMPERATUR-/BEOLKOMPATIBLES HOCHGRADIG SKALIERBARES GRAPHENSYNTHESEWERKZEUG
OUTIL DE SYNTHÈSE DE GRAPHÈNE HAUTEMENT EXTENSIBLE, COMPATIBLE AVEC LE BEOL/BASSE TEMPÉRATURE

(30) Priority: 12.07.2022 US 202217863232
(43) Date of publication of application: 17.01.2024
(60) Divisional application: 25222870.5 / 4 694 663
(73) Proprietor: Destination 2D Inc., San Jose, CA 95131 (US)
(72) Inventor: Banerjee, Kaustav, San Francisco, CA 94107 (US); Iyengar, Ravi, San Francisco, CA 94107 (US); Rupesinghe, Nalin, San Francisco, CA 94107 (US); Sundar, Satish, San Francisco, CA 94107 (US)
(74) Representative: Hoffmann Eitle

(56) References cited:
- US-A1- 2015 206 748
- US-A1- 2024 295 018
- US-B2- 8 470 400
- US-B2- 9 129 811

## Description

### CLAIM OF PRIORITY

This application claims priority to United States Patent Application No. 17/863,232, filed on 12-JUL-2022, and titled LOW-TEMPERATURE/BEOL-COMPATIBLE HIGHLY SCALABLE GRAPHENE SYNTHESIS TOOL.

### BACKGROUND

Solid-phase diffusion of atoms in a "material stack" forming a "diffusion-couple" can be leveraged to synthesize high-quality thin-films at relatively low temperatures, needed in a wide range of applications covering microelectronics, optoelectronics, bioelectronics, quantum computing, and many more. However, enabling such solid-phase diffusion assisted thin-film growth; particularly over large "wafer-scale" (e.g., 200mm, 300mm, etc.) substrates, and within reasonable growth times, require design and fabrication of novel apparatus that can allow uniform application of a wide range of temperatures and pressures over the entire surface area of the semiconductor wafer or any other substrate forming the diffusion-couple. A core component of such an apparatus is a reactor that is not only capable of hosting such large area substrates but also allow a chemically purged environment, heated large-area substrates with near-zero temperature non-uniformity, as well as facile mechanisms to apply relatively large and uniform mechanical pressures (e.g., up to 1000 psi (6894,757 kPa), etc.) to the diffusion-couple. It is noted that in some examples, atmospheric pressure can be utilized.

An imminent need for such a large-area diffusion-couple is in the emerging field of atomically-thin two-dimensional (2D) materials, particularly graphene or multi-layered-graphene (MLG) (essentially a single or multiple atomic layers of carbon atoms arranged in a hexagonal lattice), that must be directly synthesized over a desired substrate (typically a dielectric or a metal) without the need for a transfer-step that is considered unfeasible and cost-ineffective in the mainstream electronics (or CMOS) industry. Such graphene/MLG layers are preferred materials in several back-end-of-line or BEOL (refers to process steps in chip manufacturing after the formation of the active devices such as transistors and diodes) applications, particularly on-chip interconnects. However, BEOL interconnects must be synthesized under a strict thermal budget of < 500 °C to avoid any damage to the underlying active devices (e.g., transistors, diodes, etc., via increased diffusion of impurities).

Recent advances in graphene/MLG synthesis at BEOL-compatible temperatures have brought to the forefront the utility of the diffusion-couple for graphene/MLG growth, where a layer of carbon-source (e.g. in the form of powder, slurry, or amorphous-carbon film) deposited over a sacrificial metallic film (such as Nickel) lying over a SiO2/Si substrate forms the diffusion-couple. Application of appropriate mechanical pressure (65-80 psi (448,159 kPa to 551,581 kPa)) on the carbon source at a relatively low temperature (<450 °C) has been shown to be sufficient to allow high-quality graphene/MLG growth, albeit over relatively small (1-2 inches) substrates. Hence, to allow this technique to be integrated in the mainstream CMOS technology, a scaled up (200/300mm) diffusion-couple apparatus needs to be designed and fabricated. This technique/apparatus is also extendable to a wide range of substrates of different geometries and configurations and to other applications that inherently require a low thermal budget (< 500 °C).
The following document is cited as being a pertinent prior art illustration:
US 9129811 B2 discloses a method and board for growing high-quality graphene layer using high pressure annealing.
The following document is also cited as being complementary prior art illustration:
US 8 470 400 B2 discloses a process and apparatus for graphene synthesis by chemical vapor deposition.

### SUMMARY OF THE INVENTION

In one aspect, a highly scalable diffusion-couple apparatus includes a transfer chamber configured to load a wafer into a process chamber (e.g., a reactor). The process chamber is configured to receive the wafer substrate from the transfer chamber. The process chamber comprises a chamber for growth of a diffusion material on any target substrate (e.g., such as a silicon wafer). A heatable bottom plate or disk includes a first heating mechanism. The heatable bottom disk is fixed and heatable to a specified temperature. The wafer is placed on the heatable bottom disk. A heatable top disk comprising a second heating mechanism. The heatable top disk is configured to move up and down along an x axis and an x prime axis to apply a mechanical pressure to the wafer on the heatable bottom disk. While the heatable top disk applies the mechanical pressure to the diffusion couple, while the chamber pressure is maintained at a specified low value. The first heating mechanism and the second heating mechanism can be independently tuned to any value in the working range (e.g., from room temperature to 500°C).

In another aspect, a method for migration (e.g., diffusion) of a deposition material across a diffusion couple deposited on a substrate to the substrate surface includes using a reactor system to facilitate the migration of one or more diffusion materials across a diffusion couple to a substrate by applying a specified pressure to facilitate the migration of the one or more diffusion materials across the diffusion couple to the substrate, and applying a temperature to facilitate the migration of the one or more diffusion materials across a diffusion couple to the substrate.

### BRIEF DESCRIPTION OF THE DRAWINGS

The present application can be best understood by reference to the following description taken in conjunction with the accompanying figures, in which like parts may be referred to by like numerals.
**Figure 1** illustrates an example top-view of the graphene process and transfer chambers of a graphene synthesis tool, according to some embodiments.
**Figure 2** illustrates an example schematic view of the internal elements of the process chamber, according to some embodiments.
**Figure 3** illustrates an example graphene synthesis tool process, according to some embodiments.
**Figure 4** illustrates an example process for migration (e.g., diffusion) of a deposition material across a diffusion couple metal deposited on a substrate (e.g., Si wafer) forming a diffusion-couple, to the substrate surface, according to some embodiments.
**Figure 5** illustrates another example process for the migration of a deposition material across a diffusion couple metal deposited on a substrate to the substrate surface, according to some embodiments.
**Figure 6** illustrates an example process that uses top and bottom heaters to compress and heat a substrate with uniform pressure and temperature, according to some embodiments.

The Figures described above are a representative set and are not exhaustive with respect to embodying the invention.

### DESCRIPTION

Disclosed are a system, method, and article of manufacture for low-temperature/BEOL-compatible highly scalable graphene synthesis tool. The following description is presented to enable a person of ordinary skill in the art to make and use the various embodiments as long as they belong to the scope of the invention which is defined by the appended claims.

Descriptions of specific devices, techniques, and applications are provided only as examples. Various modifications to the examples described herein will be readily apparent to those of ordinary skill in the art, and the general principles defined herein may be applied to other examples and applications without departing from the scope of the invention which is defined by the appended claims.

Reference throughout this specification to "one embodiment," "an embodiment," "one example," or similar language means that a particular feature, structure, or characteristic described in connection with the embodiment is included in at least one embodiment of the present invention. Thus, appearances of the phrases "in one embodiment," "in an embodiment," and similar language throughout this specification may, but do not necessarily, all refer to the same embodiment.

Furthermore, the described features, structures, or characteristics of the invention may be combined in any suitable manner in one or more embodiments. In the following description, numerous specific details are provided, such as examples of programming, software modules, user selections, network transactions, database queries, database structures, hardware modules, hardware circuits, hardware chips, etc., to provide a thorough understanding of embodiments of the invention. One skilled in the relevant art can recognize, however, that the invention may be practiced without one or more of the specific details, or with other methods, components, materials, and so forth. In other instances, well-known structures, materials, or operations are not shown or described in detail to avoid obscuring aspects of the invention.

The schematic flow chart diagrams included herein are generally set forth as logical flow chart diagrams. As such, the depicted order and labeled steps are indicative of one embodiment of the presented method. Other steps and methods may be conceived that are equivalent in function, logic, or effect to one or more steps, or portions thereof, of the illustrated method. Additionally, the format and symbols employed are provided to explain the logical steps of the method and are understood not to limit the scope of the method. Although various arrow types and line types may be employed in the flow chart diagrams, they are understood not to limit the scope of the corresponding method. Indeed, some arrows or other connectors may be used to indicate only the logical flow of the method. For instance, an arrow may indicate a waiting or monitoring period of unspecified duration between enumerated steps of the depicted method. Additionally, the order in which a particular method occurs may or may not strictly adhere to the order of the corresponding steps shown.

### DEFINITIONS

Back-End-Of-Line (BEOL) is the second portion of IC fabrication where the interconnects and other elements are formed between and over the individual devices (primarily the transistors) on the wafer (e.g., the metallization layers) separated by intra-layer or inter-layer insulators.

Complementary metal-oxide-semiconductor (CMOS) is a type of metal-oxide-semiconductor field-effect transistor (MOSFET) fabrication process that uses complementary and electrically symmetrical pairs of p-type and n-type MOSFETs for implementing logic functions.

Grain boundary (GB) is the interface between two grains and/or crystallites in a polycrystalline material.

Graphene is an allotrope of carbon consisting of a single layer of atoms arranged in a two-dimensional honeycomb lattice.

Graphene nanoribbons (GNRs) are strips of graphene with width less than one-hundred (100) nm.

Graphite is a layered crystalline form of the element carbon with its atoms arranged and covalently bonded forming a hexagonal structure within the layers.

Piezoelectricity is the electric charge that accumulates in certain solid materials in response to applied mechanical stress.

Resistance temperature detectors (RTDs) are sensors used to measure temperature by monitoring the change in the electrical resistance of a conductor with temperature. RTD elements can consist of a length of fine wire wrapped around a heat-resistant ceramic or glass core but other constructions are also used.

Silicon dioxide is an oxide of silicon and an insulator with the chemical formula SiO₂.

Wafer is a thin slice of semiconductor (e.g. a crystalline silicon, germanium) used for the fabrication of integrated circuits, etc.

### EXAMPLE LOW-TEMPERATURE/BEOL-COMPATIBLE HIGHLY SCALABLE GRAPHENE SYNTHESIS TOOL

It is noted that the following example embodiments discuss a graphene source by way of example. However, other carbon-sources (including any carbon carrying compound) can be utilized in other example embodiments.

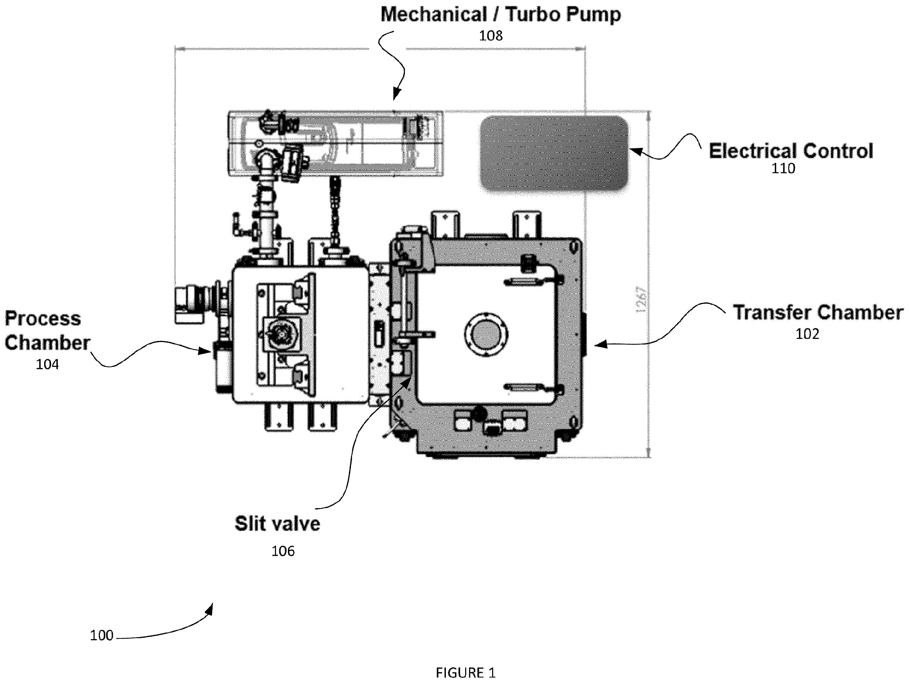

**Figure 1** illustrates an example top-view of the graphene process and transfer chambers of a carbon-source synthesis tool 100, according to some embodiments. It is noted that in other example embodiments, other diffusion materials (other elements in the periodic table suitable for a specific diffusion metal and application) than carbon-sources can be utilized. Carbon-source synthesis tool 100 can be a low-temperature/BEOL-compatible scalable graphene (and/or other carbon source) synthesis tool. Carbon-source synthesis tool 100 includes transfer chamber 102. Transfer chamber 102 is used to load the wafer. The wafer can be of various sizes (e.g. 300 mm, 200 mm, 150 mm, etc.). An operator/user can place the wafer in transfer chamber 102. The transfer chamber 102 is then closed and sealed. The pressure of the transfer chamber 102 is equalized with the pressure of the process chamber 104. Once the pressure is equalized, the wafer is then pushed to the process chamber 104. It is noted that the wafer can be returned to the transfer chamber 102 after implementation of the deposition and other fabrication methods.

The process chamber 104 and the transfer chamber 102 are connected via a slit valve 108. Slit valve 108 automatically opens once the pressures inside the two chambers are equalized.

The process chamber 104 is the main chamber (or reactor) for growth of graphene (and/or other carbon material) on the wafer. A slightly larger than 300 mm sized substrate is located in the process chamber 104 (e.g. see heated bottom substrate 208). Process chamber 104 is equipped with a heater system. A heated top plate or disk is located in the process chamber 104 as well (e.g. see heated top substrate 206). The heated top disk has its own heating mechanism as well (e.g. see heating power supply 202). In this way, both the lower disk on which the wafer is placed and the heated top disk can be heated independently. For example, the lower disk can be heated and the top disk can be kept at approximately room temperature (or vice versa). The liner surfaces (covering the disks) can be made of graphite, though other materials such as aluminum nitride, quartz, silicon carbide coated graphite, etc. can be employed. Several such materials are possible - generally speaking materials which permit good heat transfer and distribution of pressure can be considered. Flatness and surface finish of the liner can be a key factor to ensure appropriate heat and pressure distribution.

Mechanical/turbo pump 108 can be used to control pressure in process chamber 104 and/or transfer chamber 102. Mechanical pump(s) can be used to lower pressure in process chamber 104 (e.g. 10⁻³ torr). The turbo pump can be a more powerful pump that is used to lower the pressure even further (e.g. 10⁻⁷ torr). Low pressure is desired to purge the chamber of any impurities during the operation of the diffusion-couple.

Electrical control 110 can be used to operate carbon-source synthesis tool 100. Electrical control 110 can include computer processor(s) and software systems. Users can input commands, view status of various operations of carbon-source synthesis tool 100, etc.

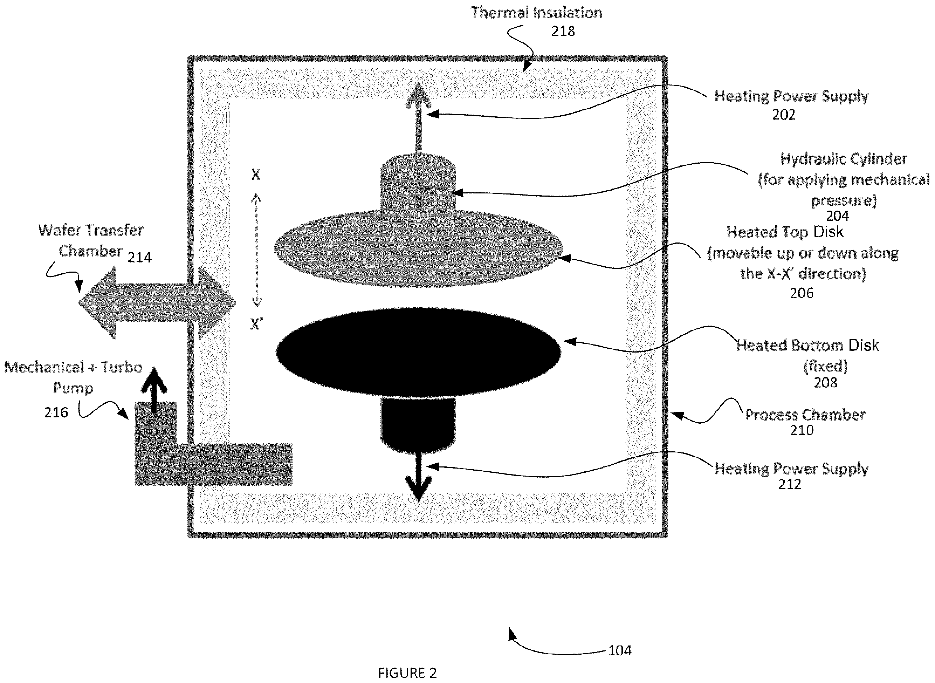

**Figure 2** illustrates an example schematic view of the internal elements of process chamber 104, according to some embodiments. Wafer transfer chamber 214 provided shows transfer of the wafer back and forth to transfer chamber 102 from process chamber 104. Heated bottom disk 208 can be fixed and can be heated to a specified temperature (e.g. 500 °C, etc.). Heat power supply 220 can maintain heat on the heat bottom disk 208. This can be done with a ±3 °C uniformity (and/or near-zero non-uniformity) across the heat bottom disk 208. Heated top disk 206 can move up and down along an x and x prime axis. Heat top disk 206 has an independent heating supply (e.g. heat power supply 202). Heated top disk 206 can be operated with hydraulic cylinder 204, a motor, and the like. Heated top disk 206 can be moved to provide mechanical pressure. By way of example, this pressure can be 50 to 125 psi (344,738 kPa to 861,845 kPa). The wafer is inserted on top of heated bottom disk 208. While the heated top disk 206 applies mechanical pressure to the diffusion-couple while the chamber pressure is maintained at a low value. This pressure can be for example, 10⁻⁶ to 10⁻⁷ torr to prevent contamination of the growth process. Chamber pressure can be regulated by mechanical/turbo pump 216.

An example operation of process chamber 104 is now discussed. Process chamber 104 can be used to deposit/grow a number of layers (e.g. monolayer or few-layer graphene structures, or multi-layer graphene structures). To grow graphene, a graphene source is deposited on a thin film of nickel (e.g., 100 nm in thickness). The graphene source (and/or other carbon-source) can be, inter alia: a graphite powder, a liquid/slurry form as a solvent with graphite, a layer of amorphous carbon deposited on nickel. Different deposition methods and tools can be utilized to deposit the thin film of nickel followed by the carbon source deposition on top of the nickel. The applied mechanical pressure breaks up the graphite source into carbon atoms, which then diffuse through the nickel and then recombine on the other side of the nickel film on top of the target substrate (such as a dielectric layer on a Si wafer). Once the formation of the desired number of graphene layers is completed, the nickel film and the carbon source are then removed.

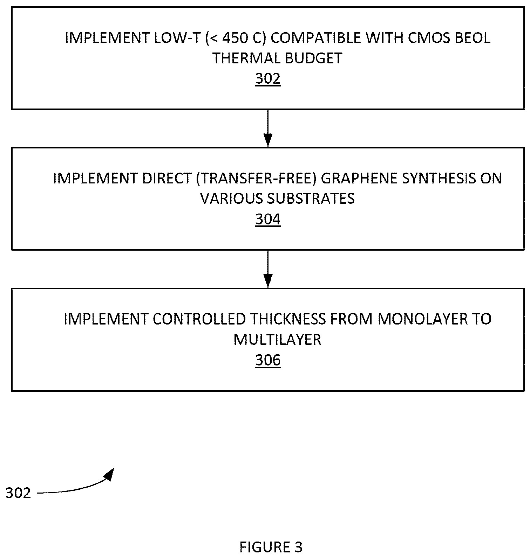

**Figure** 3 illustrates an example graphene synthesis tool process 300, according to some embodiments. Graphene synthesis tool process 300 can be used to operate carbon-source synthesis tool 100. Graphene synthesis tool process 300 can grow graphene at relatively low temperatures (e.g. 300- 450 °C, etc.). It is noted that when process chamber 104 is below ^{~}450 °C then it can be compatible with a CMOS/BEOL thermal budget. BEOL are process steps that take place after front-end-of-line transistors are fabricated. Once a fabrication process has built the transistors on the wafer, the subsequent processing steps should be within the ^{~}450°C thermal budget to avoid damage to the transistors and various junctions that may lead to shorts and reliability issues.

Graphene synthesis tool process 300 synthesize graphene while the number of layers can be controlled by adjusting process parameters. Graphene synthesis tool process 300 can directly grow on top of any substrate (e.g., dielectric/Si substrate, metallic substrate, etc.). Graphene synthesis tool process 300 can synthesize graphene to thin/few layer coating of a metallic substrate.

More specifically, in step 302, graphene synthesis tool process 300 can implement low-temperature (e.g., < 450 °C) graphene films compatible with a CMOS/BEOL thermal budget. In step 304, graphene synthesis tool process 300 can implement a direct (e.g., transfer-free) graphene synthesis on various substrates. In step 306, graphene synthesis tool process 300 can implement controlled thickness from monolayer to multilayer.

### EXAMPLE EMBODIMENTS

An example embodiment can start with a wafer (e.g. Si/SiO₂), then deposit a thin film of a catalyst metal thin-film such as nickel. The morphology of the catalyst film can be tuned during the deposition or after deposition (e.g., via annealing etc.) to meet specific application needs. Then deposit a uniform distribution of carbon-source on top of Ni. A pressure of 65 to 85 psi (448,159 kPa to 586,054 kPa) is applied on the carbon-source. A disc with a diameter slightly larger than the 300 mm wafer can be used. The substrate (wafer) can be heated to 300 °C to 450°C. Once the pressure is applied, a portion of the carbon items diffuse through the Ni film. The carbon-source/Ni/SiO₂/Si can act as a diffusion-couple. The carbon atoms can recombine on the other side of the Ni (e.g., facing the SiO₂) to form a monolayer, few-layer, or multilayer graphene.

Various processing steps can then be implemented (e.g., removing remaining graphite, removing catalyst (Ni) layer, etc.).

Instead of an SiO₂, the substrate can be copper or another metal (such as cobalt, ruthenium, molybdenum, tungsten, or an alloy metal, etc.), or a low dielectric constant (low-k) material such as porous silicon-dioxide or hydrogen silsesquioxane (HSQ), etc., or even any patterned substrate formed with metals and dielectrics, etc. In this embodiment, the modification can include a sacrificial layer of amorphous carbon between the Ni and the Cu. In this way, the Ni and the Cu can be prevented from forming an alloy. In other examples, other metals can include, inter alia: Co, Ni, Ru (as both a substrate and/or a catalyst), molybdenum, etc., or a metal compound.

The thicknesses of the substrates and catalysts can be set (e.g., 100 nm, etc.). The number of layer(s) of graphene (i.e., its thickness) required can be a function of thickness of Ni along with other process parameters including time, temperature, pressure, and grain-size of the catalyst film.

The substrate wafer can be 300 mm or 200 mm or smaller/larger (450mm). A temperature controller can be used to maintain the temperature anywhere from room temperature (^{~}25 °C) to 500°C, or higher as long as process compatibility is met. The graphite powder can be spread in a uniform or pre-patterned manner. A chuck (disk) can be used to press down on the uniformly distributed graphite. Other carbon-containing compounds can also be used as a substitute.

Pressure on the substrate forming the diffusion-couple can be applied by means of mechanical force for instance by employing an instrument such as a chuck, or via any noncontact means such as increasing the substrate environment pressure by, for instance, using a gas pressure (1 bar to several 1000's of bars). A single substrate or multiple substrates as batches can be processed at once. In addition, the gas can be normal air or a specific gas such as Ar, N2 or a mixture of many such gases etc.

Application of heat can be from any source capable of generating a temperature on the substrate. In some embodiments, both the top disk and/or the bottom disk can be heatable. In some embodiments, the top substrate disk and/or the bottom substrate disk may not be heatable, and there can be another heat source such as, for example, the pressure chamber walls, etc.

### EXAMPLE SYSTEMS AND METHODS FOR MIGRATION OF A DEPOSITION MATERIAL ACROSS A DIFFUSION COUPLE DEPOSITED ON A SUBSTRATE TO A SUBSTRATE SURFACE

Example systems and methods can provide for the migration of a deposition material across a diffusion couple deposited on a substrate to the substrate surface. This approach provides many advantages for the deposition of the material.

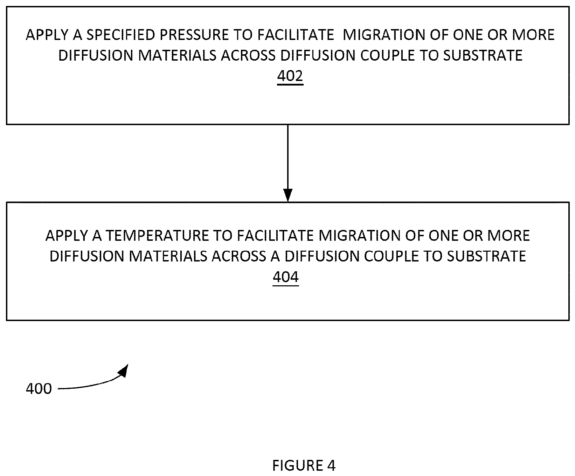

**Figure 4** illustrates an example process 400 for migration of a deposition material across a diffusion couple deposited on a substrate to a substrate surface, according to some embodiments. Process 400 can use a reactor system to facilitate the migration of one or more diffusion materials across a diffusion couple to a substrate by implementing the following steps. In step 402, process 400 can apply a specified pressure to facilitate the migration of the one or more diffusion materials across the diffusion couple to the substrate. In step 404, process 400 can apply a temperature to facilitate the migration of the one or more diffusion materials across a diffusion couple to the substrate.

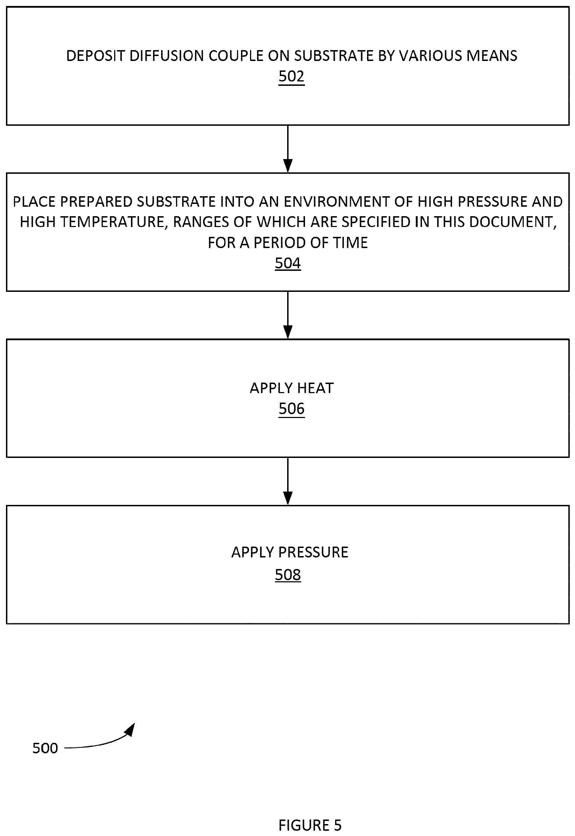

**Figure** 5 illustrates another example process 500 for or migration of a deposition material across a diffusion couple deposited on a substrate to a substrate surface, according to some embodiments. Process 500 provides the ability to deposit a material that it may not be possible to deposit directly using conventional methods. For example graphene is not known to be directly synthesized on silicon. Process 500 permits this to be realized. It is noted that the grain and other material structures of the deposited material may be tailored by appropriately varying the structure of the diffusion couple and/or process conditions.

In step 502, process 500 deposits the diffusion couple on the substrate by various means, including the most commonly used ones and then depositing some form of the material to be deposited on the substrate on top of the diffusion couple. This may herein be referred to as the prepared substrate or the layer substrate.

In step 504, process 500 places the prepared substrate into an environment of high pressure and high temperature, ranges of which are specified in this document, for a period of time.

In step 506, process 500 can perform the application of heat is accomplished through, inter alia: resistive heating, radiative heating, gas heating and the like.

In step 508, process 500 can apply pressure as well. This can be implemented through, inter alia: mechanical means, through gas pressure, through flexible membranes, through liquid pressure, and the like.

### EXAMPLE USE CASE: REACTOR WITH MECHANICAL APPLICATION OF PRESSURE AND DIRECT HEATING

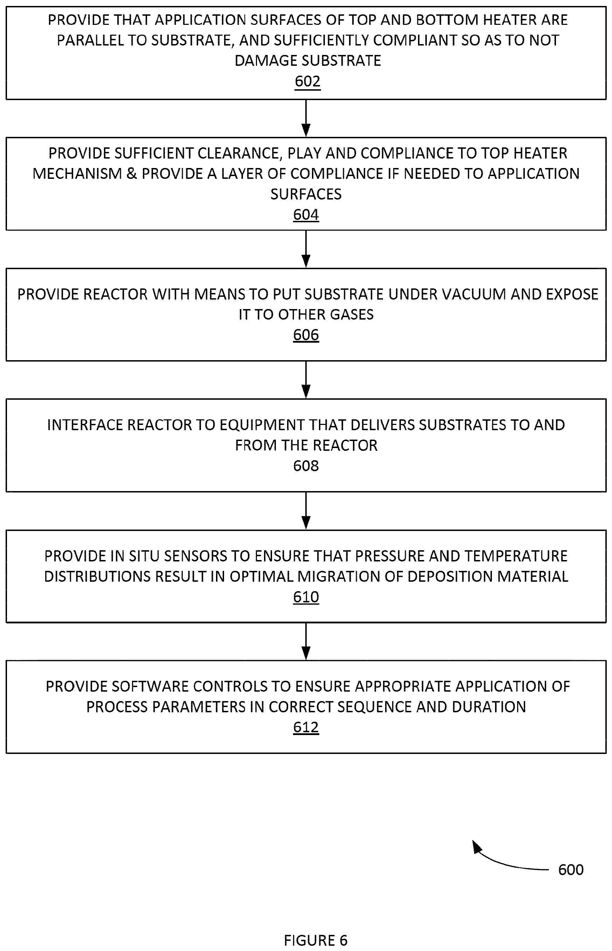

**Figure 6** illustrates an example process 600 that uses top and bottom heaters to compress a substrate with uniform pressure and temperature, according to some embodiments. Carbon-source synthesis tool 100 can be modified and/or otherwise used to implement the present example embodiment. The substrate is placed on a pedestal (e.g. disk) through means of a handler typical to the equipment industry. The pedestal has the ability to heat the substrate through direct contact. Note that the contact materials may be varied through use of appropriate liner materials. A top moving heater (embedded in a disk) then moves down and puts the substrate under pressure while at the same time heating it. When the process is completed, the substrate is returned out from the reactor (e.g. the process chamber of **Figure 2** supra, etc.).

In step 602, the application surfaces of the top and bottom heater are parallel to the substrate, and sufficiently compliant so as to not damage the substrate. This is accomplished by providing sufficient clearance and play and compliance to the top heater mechanism, as well as by providing a layer of compliance if needed to the application surfaces in step 604.

In step 606, the reactor may also be provided with the means to put the substrate under vacuum and expose it to other gases such as, inter alia, N2, Ar, He, and the like to optimize the process. Hence the reactor may be equipped with vacuum pumps as well as gas lines and a gas panel to ensure ability to put the substrate under various environments.

In step 608, the reactor may be interfaced to equipment that can deliver the substrates to and from the reactor. For example in the case of wafer processing the reactor may be attached to the facet of a transfer chamber that is equipped with a wafer handling robot that operates under high vacuum. In some examples, a slit valve can be provided to isolate the reactor from the rest of the system. A plurality of reactors may be attached to the transfer chamber to facilitate higher throughputs or production rates. There can also be reactors that deposit the diffusion couple including the source material attached to the transfer chamber, such as sputtering and CVD chambers, thereby permitting the creation of the layers on the substrate as well as the deposition of the final material on the same system.

In step 610, process 600 provides in situ sensors (e.g., in the reactor, etc.) to ensure that the pressure and temperature distributions in turn result in optimal migration of the deposition material across the diffusion couple. For example the pressure can be calibrated and monitored through the use of a pressure sensor on the step of the pedestal, through monitoring of the current drawn by the motor applying the pressure between the surfaces, through use of flexures configured as strain gauges embedded in the liner material and the like. Likewise the temperature can be monitored using thermocouples and RTDs mounted in the pedestals, use of IR sensors, phosphorus-based sensors, and the like.

In step 612, process 600 provides software controls to ensure appropriate application of the process parameters in the right sequence and duration.

Other configurations of the reactor that apply other forms of heat and pressure on the substrate are now discussed. It is noted that the aforementioned configuration is just one of many. Alternate configurations could include, inter alia:
- Heated membraned subject to high pressure (either pneumatic or hydraulic for example);
- Clamshell configurations with high temperature and high pressure heated N2, Ar, other such gases;
- Large batch reactors with the same characteristics as discussed supra;
- Clamshell in which combinations of the previously detailed approaches to heating and applying pressure to the substrates may be used. For example, high temperature and pressure gas could be fed in; high pressure could be fed in with the bottom heater being used to heat the substrate, bottom heater heats high temperature gas to accomplish the pressure function and maintain temperature, and so on;
- Quartz body with substrate placed on a susceptor and inductively heated and pressure loading accomplished using high pressure gas; and
- May also include an array of lamps in a quartz body for final temp control.

By way of example, the reactors outlined above facilitate the deposition of materials through diffusion couples, as in the use of deposition of graphene onto a silicon wafer across a nickel layer. The deposition method using diffusion couples can be applied to a wider range of deposition materials and diffusion materials.

The following sections provide certain ranges of operation for the system, as well as parameter ranges for desired material structures, composition, and the like for optimal process results.

As noted earlier the use of this method to permit migration of one material across a diffusion couple permits deposition of a material on substrate where it may previously not have been possible through other traditional deposition methods (e.g., graphene is difficult to grow directly on Si or SiO2). The systems described here facilitate the growth of graphene on Si/SiO2 by application of pressure and temperature on the carbon source deposited on a Ni layer that is in turn deposited on the Si wafer, etc.).

It is noted that the reactor can be implemented as a batch reactor and/or single substrate (wafer) reactor. It is noted that in single substrate configurations finer substrate to substrate process control than with a batch reactor can be accomplished. A method of creating a batch process with a single wafer architecture can also be realized by employing a stack of wafers between the two heaters.

### CONCLUSION

Although the present embodiments have been described with reference to specific example embodiments, various modifications and changes can be made to these embodiments without departing from the scope of the invention which is defined by the appended claims. Accordingly, the specification and drawings are to be regarded in an illustrative rather than a restrictive sense.

## Claims

1. A graphene diffusion apparatus, comprising:
a process chamber (104) configured for growth of a diffusion graphene on a substrate and comprising:
a heatable bottom disk (208) comprising a first heating mechanism, wherein the heatable bottom disk is fixed and heatable to a specified temperature, and wherein the substrate is placed on the heatable bottom disk;
a heatable top disk (206) comprising a second heating mechanism, wherein the heatable top disk is configured to move towards the heatable bottom disk and apply a mechanical pressure to the substrate positioned on the heatable bottom disk, and wherein while the heatable top disk applies the mechanical pressure a chamber pressure is maintained at a specified low value;
wherein the first heating mechanism and the second heating mechanism are tuned independently; and,
wherein, pressure application surfaces of the heatable top disk and the heatable bottom disk are parallel to the substrate.

2. The apparatus of claim 1, further comprising one or more pumps configured to control a pressure value in the process chamber to between 10⁻³ torr to 10⁻⁷ torr.

3. The apparatus of claim 1, wherein the substrate comprises a silicon wafer of a 300 mm diameter, a 200 mm diameter, or a 150 mm diameter.

4. The apparatus of claim 1, wherein the heatable bottom disk comprises a 300 mm disk.

5. The apparatus of claim 1, wherein the heatable bottom disk is heated to 500 °C with a ±3 °C uniformity across the heat bottom disk while the heatable top disk applies the mechanical pressure to the wafer.

6. The apparatus of claim 5, wherein the heatable top disk applies 50 psi to 125 psi (344,738 kPa to 861,845 kPa) of mechanical pressure to the wafer.

7. The apparatus of claim 1, wherein the heatable top disk applies the mechanical pressure while the chamber pressure is maintained at 10⁻⁶ to 10⁻⁷ torr to prevent contamination of the growth process.

8. The apparatus of claim 1, wherein a direct synthesis of high-quality atomically-thin film is performed in the process chamber.

9. The apparatus of claim 1, wherein the apparatus is integrated in a complementary metal-oxide-semiconductor (CMOS) microelectronics manufacturing process.

10. The apparatus of claim 1, further comprising a liner with a surface is composed of graphite.

11. The apparatus of claim 10, wherein the liner comprises an Aluminum Nitride, quartz, or a SiC coated graphite.

12. A method for migration of a deposition material across a diffusion couple deposited on a substrate to a substrate surface comprising:
placing a substrate on a first heatable plate (208) inside a processing chamber (104);
actuating a vacuum pump (216) to evacuate the processing chamber and thereby reduce pressure inside the processing chamber;
activating a first heater inside the first heatable plate;
activating a second heater inside a second heatable plate (206);
moving at least one of the first heatable plate and the second heatable plate towards each other so that the substrate is sandwiched between, and is being mechanically compressed by the first heatable plate and the second heatable plate, while ensuring that pressure application surfaces of the first heatable plate and the second heatable plate are parallel to the substrate.

13. The method of claim 12, further comprising the step of depositing a diffusion couple layer on the substrate prior to the step of placing a substrate on a first heatable plate inside a processing chamber.

14. The method of claim 12, wherein the reactor system uses a flexible pressurized membrane to apply the pressure to facilitate the migration of the materials across a diffusion couple to the substrate.

15. The method of claim 12, further comprising using a heated gas to apply the temperature to facilitate the migration of the one or more diffusion materials across a diffusion couple to the substrate.

16. The method of claim 12, further comprising using a radiative heating to apply the temperature to facilitate the migration of the one or more diffusion materials across the diffusion couple to the substrate.

17. The method of claim 12 further comprising:
using an inductive heating of a carrier on which the substrate sits or a top movable disk to facilitate the migration of the one or more diffusion materials across a diffusion couple to the substrate;
using an approximate compliance in one or more mechanisms for a direct pressure application to ensure a uniform pressure on the substrate and to prevent a breakage of the substrate;
using a compliant high thermal conductivity material at the pressure application surfaces to ensure uniform application of pressure without breakage of the substrate;
using the current drawn by the actuator used for application of pressure to the substrate as a measure of the applied pressure;
using a pressure transducer to measure the pressure applied to the substrate;
using a plurality of flexures and leaf springs configured as strain gages and embedded in the pedestals to measure the pressure applied to the substrate; and
using a plurality of reactor configurations capable of processing multiple substrates for batch processing of the substrates.

## Patentansprüche

1. Graphen-Diffusionsvorrichtung, umfassend:
eine Prozesskammer (104), die für Wachstum eines Diffusionsgraphen auf einem Substrat konfiguriert ist und Folgendes umfasst:
eine beheizbare untere Scheibe (208), umfassend einen ersten Heizmechanismus, wobei die beheizbare untere Scheibe fixiert ist und auf eine definierte Temperatur beheizbar ist und wobei das Substrat auf der beheizbaren unteren Scheibe platziert ist;
eine beheizbare obere Scheibe (206), umfassend einen zweiten Heizmechanismus, wobei die beheizbare obere Scheibe konfiguriert ist, um sich in Richtung der beheizbaren unteren Scheibe zu bewegen und einen mechanischen Druck auf das auf der beheizbaren unteren Scheibe positionierte Substrat auszuüben, und wobei ein Kammerdruck auf einem definierten niedrigen Wert gehalten wird, während die beheizbare obere Scheibe den mechanischen Druck ausübt;
wobei der erste Heizmechanismus und der zweite Heizmechanismus unabhängig voneinander eingestellt werden; und
wobei die Druckausübungsoberflächen der beheizbaren oberen Scheibe und der beheizbaren unteren Scheibe parallel zu dem Substrat verlaufen.

2. Vorrichtung nach Anspruch 1, ferner umfassend eine oder mehrere Pumpen, die konfiguriert sind, um einen Druckwert in der Prozesskammer auf zwischen 10⁻³ Torr und 10⁻⁷ Torr zu regeln.

3. Vorrichtung nach Anspruch 1, wobei das Substrat einen Siliziumwafer mit einem Durchmesser von 300 mm, einem Durchmesser von 200 mm oder einem Durchmesser von 150 mm umfasst.

4. Vorrichtung nach Anspruch 1, wobei die beheizbare untere Scheibe eine Scheibe mit einem Durchmesser von 300 mm umfasst.

5. Vorrichtung nach Anspruch 1, wobei die beheizbare untere Scheibe mit einer Homogenität von ±3 °C über die beheizbare untere Scheibe auf 500 °C erhitzt wird, während die beheizbare obere Scheibe den mechanischen Druck auf den Wafer ausübt.

6. Vorrichtung nach Anspruch 5, wobei die beheizbare obere Scheibe einen mechanischen Druck von 50 psi bis 125 psi (344,738 kPa bis 861,845 kPa) auf den Wafer ausübt.

7. Vorrichtung nach Anspruch 1, wobei die beheizbare obere Scheibe den mechanischen Druck ausübt, während der Kammerdruck auf 10⁻⁶ bis 10⁻⁷ Torr gehalten wird, um eine Kontamination des Wachstumsprozesses zu verhindern.

8. Vorrichtung nach Anspruch 1, wobei in der Prozesskammer eine direkte Synthese eines atomar dünnen Films von hoher Qualität durchgeführt wird.

9. Vorrichtung nach Anspruch 1, wobei die Vorrichtung in einen Herstellungsprozess für Mikroelektronik mit einem komplementären Metall-Oxid-Halbleiter (CMOS) integriert ist.

10. Vorrichtung nach Anspruch 1, ferner umfassend eine Auskleidung mit einer Oberfläche aus Graphit.

11. Vorrichtung nach Anspruch 10, wobei die Auskleidung Aluminiumnitrid, Quarz oder SiC-beschichteten Graphit umfasst.

12. Verfahren zur Migration eines Abscheidungsmaterials über ein auf einem Substrat abgeschiedenen Diffusionspaar zu einer Substratoberfläche, umfassend:
Platzieren eines Substrats auf einer ersten beheizbaren Platte (208) innerhalb einer Verarbeitungskammer (104);
Betätigen einer Vakuumpumpe (216), um die Verarbeitungskammer zu entleeren und dadurch Druck innerhalb der Verarbeitungskammer zu reduzieren;
Anschalten eines ersten Heizelements innerhalb der ersten beheizbaren Platte;
Anschalten eines zweiten Heizelements innerhalb einer zweiten beheizbaren Platte (206);
Bewegen mindestens einer von der ersten beheizbaren Platte und der zweiten beheizbaren Platte in Richtung zueinander, so dass das Substrat zwischen der ersten beheizbaren Platte und der zweiten beheizbaren Platte eingeklemmt ist und durch diese mechanisch zusammengedrückt wird, während sichergestellt wird, dass die Druckausübungsoberflächen der ersten beheizbaren Platte und der zweiten beheizbaren Platte parallel zu dem Substrat verlaufen.

13. Verfahren nach Anspruch 12, ferner umfassend den Schritt des Abscheidens einer Diffusionspaarschicht auf das Substrat vor dem Schritt des Platzierens eines Substrats auf einer ersten beheizbaren Platte innerhalb einer Verarbeitungskammer.

14. Verfahren nach Anspruch 12, wobei das Reaktorsystem eine flexible druckbeaufschlagte Membran verwendet, um den Druck auszuüben, um die Migration der Materialien über ein Diffusionspaar zu dem Substrat zu erleichtern.

15. Verfahren nach Anspruch 12, ferner umfassend Verwenden eines erhitzten Gases, um die Temperatur anzuwenden, um die Migration des einen oder der mehreren Diffusionsmaterialien über ein Diffusionspaar zu dem Substrat zu erleichtern.

16. Verfahren nach Anspruch 12, ferner umfassend Verwenden von Strahlungsheizen, um die Temperatur anzuwenden, um die Migration des einen oder der mehreren Diffusionsmaterialien über das Diffusionspaar zu dem Substrat zu erleichtern.

17. Verfahren nach Anspruch 12, ferner umfassend:
Verwenden von induktivem Heizen eines Trägers, auf dem das Substrat aufliegt, oder einer oberen bewegbaren Scheibe, um die Migration des einen oder der mehreren Diffusionsmaterialien über ein Diffusionspaar zu dem Substrat zu erleichtern;
Verwenden einer annähernden Nachgiebigkeit in einem oder mehreren Mechanismen für eine direkte Druckausübung, um einen gleichmäßigen Druck auf das Substrat sicherzustellen und einen Bruch des Substrats zu verhindern;
Verwenden eines nachgiebigen Materials mit hoher Wärmeleitfähigkeit an den Druckausübungsoberflächen, um eine gleichmäßige Ausübung von Druck ohne Bruch des Substrats sicherzustellen;
Verwenden des durch den Aktuator, der zur Ausübung von Druck auf das Substrat verwendet wird, aufgenommenen Stroms als ein Maß des ausgeübten Drucks;
Verwenden eines Druckwandlers, um den auf das Substrat ausgeübten Druck zu messen;
Verwenden einer Vielzahl von Biegeelementen und Blattfedern, die als Dehnungsmessstreifen konfiguriert und in die Sockel eingebettet sind, um den auf das Substrat ausgeübten Druck zu messen; und
Verwenden einer Vielzahl von Reaktorkonfigurationen, die in der Lage ist, mehrere Substrate für eine Stapelverarbeitung der Substrate zu verarbeiten.

## Revendications

1. Appareil de diffusion de graphène, comprenant :
une chambre de traitement (104) configurée pour la croissance d'un graphène de diffusion sur un substrat et comprenant :
un disque inférieur chauffant (208) comprenant un premier mécanisme de chauffage, dans lequel le disque inférieur chauffant est fixé et chauffant à une température spécifiée, et dans lequel le substrat est placé sur le disque inférieur chauffant ;
un disque supérieur chauffant (206) comprenant un second mécanisme de chauffage, dans lequel le disque supérieur chauffant est configuré pour se déplacer vers le disque inférieur chauffant et appliquer une pression mécanique au substrat positionné sur le disque inférieur chauffant, et dans lequel, pendant que le disque supérieur chauffant applique la pression mécanique, une pression de chambre est maintenue à une valeur basse spécifiée ;
dans lequel le premier mécanisme de chauffage et le second mécanisme de chauffage sont réglés indépendamment ; et,
dans lequel les surfaces d'application de pression du disque supérieur chauffant et du disque inférieur chauffant sont parallèles au substrat.

2. Appareil selon la revendication 1, comprenant en outre une ou plusieurs pompes configurées pour commander une valeur de pression dans la chambre de traitement entre 10⁻³ torr et 10⁻⁷ torr.

3. Appareil selon la revendication 1, dans lequel le substrat comprend une plaquette de silicium d'un diamètre de 300 mm, de 200 mm ou de 150 mm.

4. Appareil selon la revendication 1, dans lequel le disque inférieur chauffant comprend un disque de 300 mm.

5. Appareil selon la revendication 1, dans lequel le disque inférieur chauffant est chauffé à 500 °C avec une uniformité de ±3 °C à travers le disque inférieur chauffant pendant que le disque supérieur chauffant applique la pression mécanique sur la plaquette.

6. Appareil selon la revendication 5, dans lequel le disque supérieur chauffant applique une pression mécanique de 50 psi à 125 psi (344 738 kPa à 861 845 kPa) à la plaquette.

7. Appareil selon la revendication 1, dans lequel le disque supérieur chauffant applique la pression mécanique pendant que la pression de chambre est maintenue à 10⁻⁶ à 10⁻⁷ torr pour éviter la contamination du processus de croissance.

8. Appareil selon la revendication 1, dans lequel une synthèse directe d'un film atomiquement mince de haute qualité est réalisée dans la chambre de traitement.

9. Appareil selon la revendication 1, dans lequel l'appareil est intégré dans un processus de fabrication de microélectronique à semi-conducteur métal-oxyde complémentaire (CMOS).

10. Appareil selon la revendication 1, comprenant en outre un revêtement dont la surface est composée de graphite.

11. Appareil selon la revendication 10, dans lequel le revêtement comprend du nitrure d'aluminium, du quartz ou du graphite recouvert de SiC.

12. Procédé de migration d'un matériau de dépôt à travers un couple de diffusion déposé sur un substrat vers une surface de substrat comprenant :
le placement d'un substrat sur une première plaque chauffante (208) à l'intérieur d'une chambre de traitement (104) ;
l'actionnement d'une pompe à vide (216) pour évacuer la chambre de traitement et ainsi réduire la pression à l'intérieur de la chambre de traitement ;
l'activation d'un premier élément chauffant à l'intérieur de la première plaque chauffante ;
l'activation d'un second élément chauffant à l'intérieur d'une seconde plaque chauffante (206) ;
le déplacement d'au moins l'une de la première plaque chauffante et de la seconde plaque chauffante vers l'autre de sorte que le substrat est pris en sandwich entre elles et est comprimé mécaniquement par la première plaque chauffante et la seconde plaque chauffante, tout en veillant à ce que les surfaces d'application de pression de la première plaque chauffante et de la seconde plaque chauffante soient parallèles au substrat.

13. Procédé selon la revendication 12, comprenant en outre l'étape de dépôt d'une couche de couple de diffusion sur le substrat avant l'étape de placement d'un substrat sur une première plaque chauffante à l'intérieur d'une chambre de traitement.

14. Procédé selon la revendication 12, dans lequel le système de réacteur utilise une membrane flexible sous pression pour appliquer la pression afin de faciliter la migration des matériaux à travers un couple de diffusion vers le substrat.

15. Procédé selon la revendication 12, comprenant en outre l'utilisation d'un gaz chauffé pour appliquer la température afin de faciliter la migration des un ou plusieurs matériaux de diffusion à travers un couple de diffusion vers le substrat.

16. Procédé selon la revendication 12, comprenant en outre l'utilisation d'un chauffage par rayonnement pour appliquer la température afin de faciliter la migration des un ou plusieurs matériaux de diffusion à travers un couple de diffusion vers le substrat.

17. Procédé de la revendication 12, comprenant en outre :
l'utilisation d'un chauffage par induction d'un support sur lequel repose le substrat ou d'un disque mobile supérieur afin de faciliter la migration des un ou plusieurs matériaux de diffusion à travers un couple de diffusion vers le substrat ;
l'utilisation d'une compliance approximative dans un ou plusieurs mécanismes pour une application de pression directe pour assurer une pression uniforme sur le substrat et éviter une rupture du substrat ;
l'utilisation d'un matériau souple à haute conductivité thermique au niveau des surfaces d'application de pression pour assurer une application uniforme d'une pression sans rupture du substrat ;
l'utilisation du courant consommé par l'actionneur utilisé pour l'application d'une pression au substrat en tant que mesure de la pression appliquée ;
l'utilisation d'un transducteur de pression pour mesurer la pression appliquée au substrat ;
l'utilisation d'une pluralité de flexions et de ressorts à lames configurés en tant que jauges de contrainte et intégrés dans les socles pour mesurer la pression appliquée au substrat ; et
l'utilisation d'une pluralité de configurations de réacteurs capables de traiter de multiples substrats pour le traitement par lots des substrats.
